# EUROPÄISCHE PATENTSCHRIFT

(11) **EP 2 740 163 B1**
(45) Veröffentlichungstag und Bekanntmachung des Hinweises auf die Patenterteilung: **16.09.2015**
(21) Anmeldenummer: 12743443.9
(22) Anmeldetag: 31.07.2012
(51) Int. Cl.: H01L 41/047, H01L 41/053

(54) **VOLLAKTIVER PIEZOSTACK MIT PASSIVIERUNG**
FULLY ACTIVE PIEZO STACK HAVING PASSIVATION
EMPILEMENT PIÉZOÉLECTRIQUE ENTIÈREMENT ACTIF À PASSIVATION

(30) Priorität: 01.08.2011 DE 102011080234; 02.05.2012 DE 102012207276
(43) Veröffentlichungstag der Anmeldung: 11.06.2014
(73) Patentinhaber: Continental Automotive GmbH, 30165 Hannover (DE)
(72) Erfinder: RICHTER, Thomas, 93049 Regensburg (DE); KASTL, Harald, Johannes, 95686 Fichtelberg (DE); ZUMSTRULL, Claus, 93128 Regenstauf (DE)
(86) Internationale Anmeldenummer: PCT/EP2012/064951
(87) Internationale Veröffentlichungsnummer: WO 2013/017592

(56) Entgegenhaltungen:
- EP-A1- 2 343 746
- DE-A1- 10 260 853
- DE-A1-102006 062 076
- DE-A1-102009 017 434

## Beschreibung

Die vorliegende Erfindung betrifft einen vollaktiven Piezostack mit einer Passivierung.

Piezoelektrische Bauteile können beispielsweise in Form von Piezoaktoren als Vielschichtbauelemente mit einer Anzahl von jeweils alternierend angeordneten piezoelektrischen Keramikschichten und Elektrodenschichten ausgebildet sein und gewinnen in der modernen Elektrotechnik immer mehr an Bedeutung. Beispielsweise werden Piezoaktoren als Stellantriebe, in Verbindung mit Ventilen und dergleichen, eingesetzt. Piezoaktoren werden auch bei der Einspritzung eines Kraftstoffes in einen Brennraum verwendet. Hierbei steigen die Anforderungen entsprechend den gesteigerten Anforderungen an Emission und Verbrauch. Höhere Drücke und Temperaturen, sowie mehrfach Einspritzungen erfordern eine höhere Temperaturbeständigkeit des Aktors sowie eine hohe Dauerhaltbarkeit.

Ein Piezoaktor ist beispielsweise in der DE 196 46 676 C1 ausführlich beschrieben. Bei derartigen Piezokeramiken wird der Effekt ausgenutzt, dass diese sich unter einem mechanischen Druck, beziehungsweise Zug, aufladen und andererseits bei Anlegen einer elektrischen Spannung entlang der Hauptachse der Keramikschicht ausdehnen. Zur Vervielfachung der nutzbaren Längenausdehnung werden beispielsweise monolithische Vielschichtaktoren verwendet, die aus einem gesinterten Stapel dünner Folien aus Piezokeramik (beispielsweise Bleizirkonattitanat) mit eingelagerten metallischen Elektrodenschichten bestehen. Die Elektrodenschichten sind wechselseitig aus dem Stapel herausgeführt und über Außenmetallisierungen elektrisch parallel geschaltet. Auf den beiden Kontaktseiten des Stapels ist hierzu jeweils eine streifen- oder bandförmige, durchgehende Außenmetallisierung aufgebracht, die mit allen Elektrodenschichten gleicher Polarität verbunden ist.

Legt man eine elektrische Spannung an die Außenkontaktierung, so dehnen sich die Piezofolien in Feldrichtung aus. Durch die mechanische Serienschaltung der einzelnen Piezofolien wird die Nenndehnung des gesamten Stapels schon bei relativ niedrigen elektrischen Spannungen erreicht.

In der DE 102 60 853 A1 ist ein Piezoaktor und ein Verfahren zu dessen Herstellung beschrieben. Der Piezoaktor weist einen Mehrschichtaufbau von Piezolagen und dazwischen angeordneten Innenelektroden auf. Die Innenelektroden erstrecken sich hierbei nicht vollständig über den gesamten Querschnitt des Piezoaktors, und sind alternierend so angeordnet, dass sie abwechselnd jeweils bis zu einer Seitenfläche des Piezoaktors reichen und von der gegenüberliegenden Seitenfläche beabstandet sind. Somit sind Innenelektroden über eine jeweilige Außenelektrode an den gegenüber liegenden Seitenflächen abwechselnd kontaktiert. Die anderen beiden Seitenflächen des Piezoaktors sind mit einer isolierenden Schicht, insbesondere aus derselben Keramik wie die Piezolagen versehen. Die Herstellung dieser isolierenden Schicht erfolgt dadurch, dass der Piezoaktor im Grünzustand der Keramik vollständig mit einer isolierenden Schutzschicht aus demselben Keramikmaterial umgeben wird, diese gemeinsam gesintert werden und anschließend an den zu kontaktierenden beiden Seitenflächen die keramische Isolierschicht entfernt wird.

Die EP 1 808 960 A2 beschreibt einen Piezoaktor mit demselben Aufbau wie in der DE 102 60 853 A1 gezeigt, wobei auch hier dieser mit einer vollständigen Ummantelung aus einer keramischen Isolierschicht, insbesondere auf Basis von Blei-Zirkonen-Titanat, versehen ist. Eine Kontaktierung der Innenelektroden an den entsprechenden Seitenflächen erfolgt über in die isolierende Keramikschicht eingebrachte Stege oder durch Entfernen der isolierenden Keramikschicht.

Die DE 10 2005 046 599 A1 beschreibt einen piezoelektrischen Aktor für Brennstoffeinspritzventile mit einer Vielzahl von keramischen Schichten und einer Vielzahl von zwischen den keramischen Schichten angeordneten Elektrodenschichten. An den für die Elektrodenanbindung vorgesehenen Außenflächen wird der Aktor nach einem Sinterprozess zur Sinterung der keramischen Schichten bearbeitet. Hierbei sind nach der Sinterung zumindest zwei Außenflächen durch Schleifen nachbearbeitet worden, und zwar so, dass eine Verbindung erster Innenelektroden sowie zweiter Innenelektroden mit Außenelektroden ermöglicht ist. Die Anbindung der Innenelektroden an Außenelektroden erfolgt durch ein entsprechendes Verbindungsmittel, beispielsweise durch Löten.

Die DE 10 2006 043 709 A1 beschreibt eine Anordnung eines Piezoaktors in einem Gehäuse. Hier ist eine die Piezoelemente des Piezoaktors umgebende Hülse vorhanden, wobei zwischen der Hülse und dem Piezoelement eine Isolationsmasse angeordnet ist. Diese Isolationsmasse kann beispielsweise nur als Wulst ausgeführt sein und Keramikpartikel enthalten, so dass eine vorgegebene Wärmeleitfähigkeit zwischen dem Piezoaktor und der Hülse erreicht ist.

In der DE 10 2009 017 434 A1 ist ein als Stapel ausgebildetes elektronisches Bauelement, dass eine Mehrzahl von Elektrodenschichten und eine Mehrzahl von auf Anlegen eines elektrischen Feldes reagierenden Werkstoffschichten umfasst. Der Stapel umfasst weiterhin eine strukturierte Isolationsschicht, die derart ausgebildet ist, dass jede zweite Elektrodenschicht eines Stapelumfangsbereiches zur elektrischen Kontaktierung freigelegt ist. Eine elektrisch leitende Schicht ist so strukturiert ausgebildet, dass sie die Isolationsschicht im Wesentlichen ganzflächig bedeckt und eine zumindest zweidimensionale Elastizität in der Ebene des jeweiligen Stapelumfangsbereiches aufweist. Als Isolationsmaterial für die Isolationsschicht kann ein Schrumpfschlauch vorgesehen sein, der den Stapel vollständig umhüllt. An den Seiten des Stapels, an dem keine Kontaktierung der Elektroden vorgesehen ist, kann eine Passivierungsschicht vorgesehen sein, die beispielsweise durch Sprühen, Tauchen, Pinseln oder Siebdruck hergestellt wird und aus Silikon, Epoxy, Polyurethan, Polyimid besteht.

Die DE 10 2006 002 695 beschreibt ein Verfahren zur elektrischen Passivierung eines Vielschicht-Piezostacks bei dem eine elektrische Isolierung auf die Flächen des Piezostacks aufgebracht wird und in der Isolierung im Bereich der Elektroden Öffnungen erzeugt werden. Als Isolierung kann hierbei eine beispielsweise Epoxid oder Polyimid aufweisende Kunststofffolie oder ein Kunststoffschlauch auflaminiert werden. Vor der in einem zweiten Verfahrensschritt aufzubringenden Isolierung werden notwendige Kontaktierungsbereiche abgedeckt oder versiegelt.

Aus der WO 2002/089225 ist bekannt, ein Passivierungsmaterial für ein piezoelektrisches Bauteil in Vielschichtbauweise bereitzustellen, das eine Reißfestigkeit aufweist, die kleiner ist als die Haftfestigkeit des Passivierungsmaterials auf dem elektrischen Bauteil. Dabei sind u.a. Kunststoffe, Polyurethane, Harze oder Polyimide vorgesehen. Aus der US 2007 024 7025 A1 ist zudem bekannt als Passivierungsmaterial Glas zu verwenden.

DE 102 60 853 A1 beschreibt einen Piezoaktor mit einem Piezostapel, der an zwei gegenüberliegenden Seiten mit einer Keramikschicht passiviert ist.

In EP 2 343 746 A1 ist ein Piezostapel beschrieben, der von einer keramischen Passivierung innen und von zwei Kunststoff-Passivierungen außen umgeben ist.

Die Aufgabe der vorliegenden Erfindung liegt darin, einen vollaktiven Piezostack mit einer verbesserten Passivierung bereit zu stellen, welche elektrische Überschläge während des Betriebs verhindert.

Diese Aufgabe wird gelöst durch einen vollaktiven Piezostack mit Seitenflächen, wobei an zwei sich gegenüberliegenden Seitenflächen über der jeweiligen Breite eine Passivierungsschicht aus Keramik angeordnet ist und an den anderen beiden sich gegenüberliegenden Seitenflächen jeweils eine Passivierungsschicht aus Kunststoff angeordnet ist so dass alle Seitenflächen über die jeweilige Breite mit einer Passivierung versehen sind.

Für eine möglichst optimale Auslenkung der einzelnen piezoelektrischen Keramikschichten eines Vielschichtaktors bei gleichzeitig minimalem Platzbedarf erstrecken sich die jeweiligen Elektrodenschichten (auch Innenelektroden genannt) welche zwischen zwei aufeinander angeordneten piezoelektrischen Keramikschichten angeordnet sind, im Wesentlichen über den gesamten Querschnitt der Keramikschichten, d.h. des Aktors. So ein Aktor ist unter dem Begriff vollaktiver Piezostack bekannt. Das bedeutet, dass Elektrodenschichten alternierender Polarität an den seitlichen Oberflächen (im Folgenden auch Seitenflächen genannt) der Vielschichtkeramik freiliegen; im Gegensatz zu Aktoren bei denen die Innenelektroden alternierend von einer mit einer Außenkontaktierung versehenen Seite des Aktuators beabstandet sind.

Aus diesem Grund ist es erforderlich, diese freiliegenden Elektrodenschichten mit einer geeigneten Passivierung zu versehen. Bei einer Passivierung handelt es sich im allgemeinen um eine Art Schutzschicht, Isolationsschicht oder dergleichen, mittels derer elektrische Überschläge und Kurzschlüsse zwischen benachbarten Elektrodenschichten vermieden werden können. Ohne eine Passivierung könnten solche Überschläge und Kurzschlüsse, beispielsweise durch mechanische Beschädigung der Oberfläche oder durch Kontaminierung mit Verunreinigungen (beispielsweise Schleifstaub, Fingerabdrücke und dergleichen), Feuchtigkeit oder Betriebsstoffen (beispielsweise Diesel, Rapsmethylester und dergleichen), hervorgerufen werden. Derartige Beschädigungen und/oder Kontaminierungen können insbesondere im Betrieb des Aktors, aber auch während des Herstellungsprozesses hervorgerufen werden.

Eine Möglichkeit dieser isolierenden Schicht mittels eines Kunststoffes ist das Auftragen einer Lackschicht, welche als Material ein Polyimid umfassen kann. Die Familie der Polyimide hat sich für diese Anwendung aufgrund ihrer Eigenschaften hinsichtlich Glastemperatur, Temperaturbeständigkeit und Isolationseigenschaften als am besten geeignet dargestellt. Allerdings kann es bei der Passivierung mit Polyimidlack während des Auftrag- und Aushärteprozesses zu schichtigen Inhomogenitäten, und an den Kanten zu teilweise nicht ausreichender Bedeckung und somit zu elektrischen Spannungsüberschlägen in Betrieb kommen.

Mit dem erfindungsgemäßen vollaktiven Piezostack wird selbst bei Schwankungen in der Dicke des Kunststoffes eine unzureichende Bedeckung der Kanten des Piezostacks vermieden, da diese Kanten durch die keramische Passivierungsschicht entweder voll umschlossen sind oder an einer Seite der Kante die keramische Passivierungsschicht sich anschließt und die Passivierungsschicht aus Kunststoff sich von der Kante des Piezostacks noch auf die keramische Passivierungsschicht erstreckt.

Ein Vorteil der Erfindung liegt somit auch darin, dass die bei der Verwendung von Lackauftragsverfahren auftretende "Kantenflucht", das heißt schwache Benetzung der Kante, in einen Bereich verlegt werden kann, in dem kein elektrisches Feld anliegt, da die Kante keramisch passiviert ist. Desweiteren werden die Passivierungsprozesse deutlich vereinfacht und die Anzahl der Prozessschritte deutlich reduziert. Die Handhabung des passivierten Piezostacks wird durch die robustere Keramik-Passivierung ebenfalls vereinfacht. Ein weiterer Vorteil besteht darin, dass durch die Passivierung mit Keramik keine Grenzfläche zur Keramik des Piezostacks entsteht, wie beispielsweise bei Glas, was zur Stabilität des gesamten Piezostacks beiträgt. Dadurch wird auch die Haftung der Passivierung mit dem Piezostack verbessert, bzw. es entstehen keine Haftprobleme zwischen unterschiedlichen Materialien. Die Verwendung von Keramik als Passivierung eines Teiles der Seitenflächen hat den Vorteil, dass es gegenüber äußeren Einflüssen wie Temperatur, Verunreinigungen und Beschädigungen widerstandsfähiger als ein Kunststoff ist, wie zum Beispiel Polyimid.

Der Kunststoff isoliert bevorzugt den Teil der Innenelektroden des Piezostacks, welcher nicht elektrisch kontaktiert werden soll. Für den Teil der Innenelektroden, der elektrisch mit einer Außenelektrode (auch elektrische Kontaktierung genannt) verbunden werden soll, wird der Kunststoff durch ein geeignetes Verfahren entfernt und damit die Innenelektrode für eine Kontaktierung freigelegt. Die beiden Kunststoffschichten, welche für die spätere Anwendung an vorgesehenen Kontakten entfernt werden, überdecken die elektrisch zu kontaktierenden Flächen, den Plus- bzw. Minuspol. Hierdurch kann der Piezostack elektrisch angesteuert werden, und die gewünschte mechanische Auslenkung wird erreicht.

In einer weiteren Ausführungsform erstreckt sich eine keramische Passivierungsschicht zusätzlich wenigstens teilweise an einer oder an beiden der die Passivierungsschicht aus Kunststoff aufweisenden Seitenfläche. Die keramische Passivierungsschicht kann dabei bis an die elektrischen Kontaktierungen heranreichen. Dadurch wird ein verstärkter Schutz gegen Beschädigungen in einem größeren Bereich der Seitenflächen des Piezostacks erreicht. Dies ist insbesondere bei hohen Temperaturen von Vorteil, da eine erhöhte Temperaturstabilität durch die Verwendung eines einzigen Materials, Keramik, erreicht wird. Bei der Herstellung dieser Passivierung in einem Arbeitsschritt wird zusätzlich erreicht, dass sich nur ein Gefüge des keramischen Materials ausbildet. Die Seitenflächen des Piezostacks sind im Übrigen durch die keramische Passivierung vor elektrischen Überschlägen und Beschädigungen geschützt. Weiterhin ist auch hier vorteilhaft, dass ein Gefüge des keramischen Materials ausgebildet wird und sich dadurch die mechanische Stabilität und die Temperaturstabilität verbessert.

In einer weiteren Ausführungsform erstrecken sich beide keramische Passivierungsschichten zusätzlich wenigstens teilweise an eine oder an beide der die Passivierungsschicht aus Kunststoff aufweisenden Seitenfläche.

Der Kunststoff zumindest einer der Passivierungsschichten ist vorzugsweise optisch transparent. Für die Kontaktierung des vollaktiven Piezostacks wird die Passivierungsschicht an zwei gegenüberliegenden Seitenflächen des Piezostacks an jeder zweiten Innenelektrode wieder abgetragen. Dadurch liegt dann jede zweite Innenelektrode frei und kann entsprechend nach außen ankontaktiert werden. Für das Freilegen ist es günstig, wenn die Passivierungsschicht transparent ist (optische Erkennung der Elektroden durch die Schicht hindurch) und sich mit geeigneten Verfahren freilegen lässt. Für einen Laserprozess ist z.B. Polyimid gut geeignet, da diese durch Laserbearbeitung sehr gut abgetragen werden kann. Für die Passivierung an den beiden anderen Seitenflächen spielt die Möglichkeit einer Lokalisierung der Innenelektroden keine Rolle, da dort lediglich passiviert werden muss. Daher eignet sich z.B. eine keramische Passivierung sehr gut. So können eventuelle Schwierigkeiten beim Aufbringen und Aushärten einer Polyimidschicht auf diesen beiden Seitenflächen vermieden werden (Kantenüberdeckung, mehrfache Trocknungsschritte etc...), und der gesamte Herstellungsprozess wird vereinfacht.

In einer weiteren Ausführungsform ist der Kunststoff als Polyimid ausgebildet. Polyimid hat den Vorteil, dass es einen sehr hohen elektrischen Widerstand aufweist. Dadurch kann auch mit verhältnismäßig dünnen Polyimid-Schichten, im Bereich von 20 Mikrometern, eine elektrische Isolierung gegen Spannungsüberschläge erreicht werden.

Die Dicke der Passiverungsschicht aus Kunststoff kann im Bereich von 20 Mikrometer bis 70 Mikrometer, bevorzugt von etwa 50 Mikrometer liegen. Somit kann selbst bei Aufbringung des Kunststoffes als Lack mit gewissen Schwankungen der Dicke eine sichere Passivierung erreicht werden.

Die Dicke der keramischen Passivierungschichten liegt bevorzugt je nach Art der Aufbringung im Bereich von 5 Mikrometer bis zu 20 Mikrometer.

Weitere Einzelheiten und Vorteile werden in Bezugnahme auf die beigefügten Figuren erläutert.

Darin zeigen schematisch:
- Figur 1: Vollaktiver Piezostack mit reiner Kunststoff-Passivierung im Querschnitt;
- Figur 2: Vollaktiver Piezostack mit zusätzlicher keramischer Passivierung im Querschnitt;
- Figur 3: Vollaktiver Piezostack mit erweiterter keramischer Passivierung im Querschnitt.
- Figur 4: Vollaktiver Piezostack mit zusätzlicher keramischer Passivierung im Längsschnitt.

Bei der nachfolgenden Beschreibung einer bevorzugten Ausführungsform bezeichnen gleiche Bezugszeichen gleiche oder vergleichbare Komponenten.

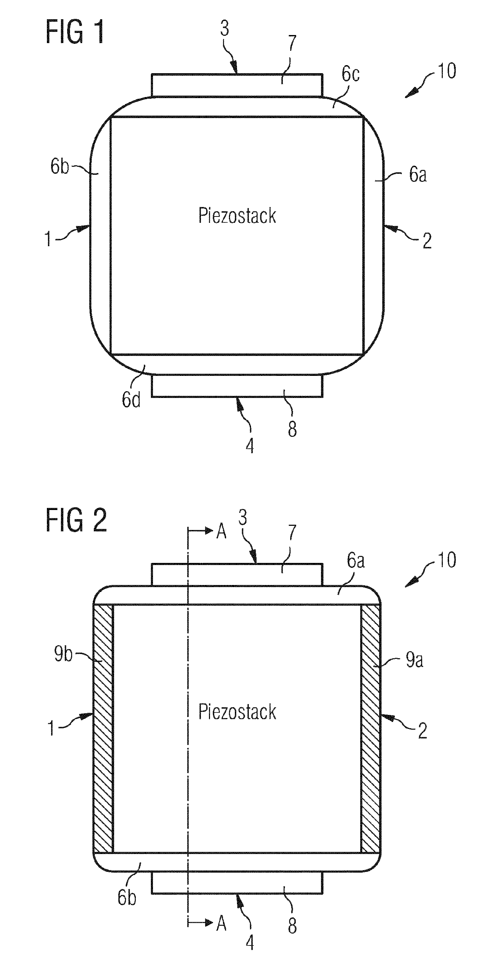

Figur 1 zeigt einen vollaktiven Piezostack 10 mit einer ersten Seitenfläche 1, zweiten Seitenfläche 2, dritten Seitenfläche 3 und vierten Seitenfläche 4, die üblicherweise ein Quadrat oder Rechteck ausbilden. Die vier Seitenflächen 1, 2, 3, 4 weisen jeweils eine Passivierungsschicht 6a, 6b, 6c, 6d auf, welche jeweils Kunststoff umfassen. Ein geeigneter Kunststoff ist temperaturbeständig, weist eine gute Haftung an Keramik auf und isoliert elektrisch. Bevorzugt wird als Kunststoff Polyimid eingesetzt. Der Piezostack 10 umfasst ferner elektrische Kontaktierungen 7, 8 (Außenelektroden), welche an zwei gegenüberliegenden Seitenflächen 3, 4 ausgebildet sind. Hierzu werden die Passivierungsschichten 6a, 6b, welche an der dritten 3 und vierten 4 Seitenfläche des Piezostacks 10 ausgebildet sind, alternierend im Bereich der elektrischen Kontaktierungen 7, 8 entfernt (in der Figur nicht sichtbar). Das heißt, dass auf jeder der dritten Seitenfläche 3 und vierten Seitenfläche 4 abwechselnd die Passivierung entfernt wird. D.h. die Passivierung einer Innenelektrode wird nur entweder jeweils an der dritten Seitenfläche 3 oder der vierten Seitenfläche 4 Seitenfläche entfernt, so dass ein Kurzschluss vermieden wird.

Bei der Passivierung mit Kunststoff wie Polyimid bzw. Polyimidlack kann es während des Auftrag- und Aushärteprozesses zu schichtigen Inhomogenitäten kommen, und an den Kanten zu teilweise nicht ausreichender Bedeckung durch die Passivierung. Dies ist in der Figur 1 an den nicht vollständig passivierten Ecken zu sehen. Dies kann im Betrieb zu elektrischen Überschlägen führen.

Figur 2 zeigt einen vollaktiven Piezostack 10 analog der Figur 1, wobei eine erste Passivierungsschicht 9a und zweite Passivierungsschicht 9b aus Keramik an der ersten Seitenfläche 1 und der zweiten Seitenfläche 2 des Piezostacks 10 ausgebildet ist.

Dadurch wird die schwache Benetzung des Kanten- bzw. Eckbereichs des Piezostacks (10) in einen Bereich verlegt, in dem kein elektrisches Feld anliegt, da die Kante mit Keramik passiviert ist.

Die erste keramische Passivierungsschicht 9a und zweite keramische Passivierungsschicht 9b der zwei gegenüberliegenden Seitenflächen 1, 2, werden bereits vor dem Sintern im Grünzustand aufgebracht und anschließend zusammen mit dem Bauteil thermisch prozessiert. Die beiden nicht keramisch passivierten Seitenflächen 3,4 werden mit Kunststoff wie Polyimid passiviert und kontaktiert.

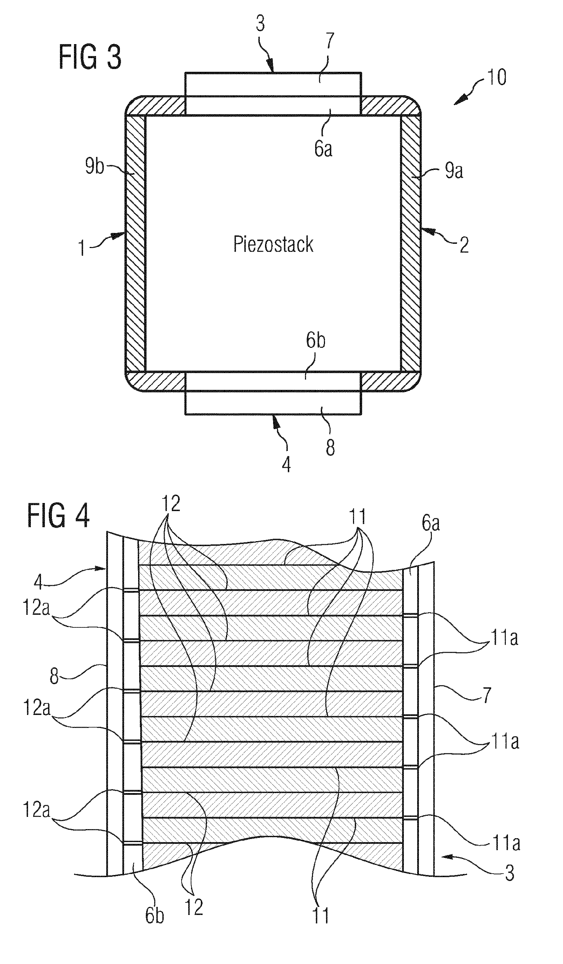

Figur 3 zeigt einen vollaktiven Piezostack 10 entsprechend der Figur 2, mit erweiterter keramischer Passivierung, wobei die erste und zweite Passivierungsschicht 9a, 9b zusätzlich wenigstens teilweise an der dritten und vierten Seitenfläche 3, 4 angeordnet sind, derart, dass diese bis an die elektrischen Kontaktierungen 7, 8 heranreichen.

Figur 4 zeigt eine Längsansicht des vollaktiven Piezostacks gemäß Figur 2 entlang des Schnittes A-A. Die Passivierungsschicht 6a weist hierbei an jeder Innenelektrode 11 eine Kontaktierung 11a auf, durch die an der Seitenfläche 3 zwischen der Innenelektrode 11 und der elektrischen Kontaktierung (Außenelektrode) 7 eine elektrische Verbindung hergestellt ist. An der gegenüberliegenden Seitenfläche 4 sind entsprechende Kontaktierungen 12a durch die Passivierungsschicht 6b vorgesehen, die die Innenelektroden 12, welche alternierend zu den Innenelektroden 11 angeordnet sind, mit der elektrischen Kontaktierung (Außenelektrode) 8 elektrisch verbinden.

Die Erfindung wird vorteilhaft für Einspritzventile in Kraftfahrzeugen verwendet.

## Patentansprüche

1. Vollaktiver Piezostack (10) mit Seitenflächen (1, 2, 3, 4), wobei
- an zwei sich gegenüberliegenden Seitenflächen (1, 2) über der jeweiligen Breite eine Passivierungsschicht (9a, 9b) aus Keramik angeordnet ist,
- an den anderen beiden sich gegenüberliegenden Seitenflächen (3,4) jeweils eine Passivierungsschicht (6a, 6b) aus Kunststoff angeordnet ist,
so dass alle Seitenflächen (1,2,3,4) über die jeweilige Breite mit einer Passivierungsschicht (9a,9b, 6a ,6b) versehen sind.

2. Piezostack (10) nach Anspruch 1, wobei zumindest eine der Keramik umfassenden Passivierungsschichten (9a, 9b) sich auf eine angrenzende Seitenfläche (3, 4) erstreckt.

3. Piezostack (10) nach Anspruch 2, wobei zumindest eine der Keramik umfassenden Passivierungsschichten (9a, 9b) sich auf beide angrenzende Seitenfläche (3, 4) erstreckt.

4. Piezostack (10) nach einem der vorhergehenden Ansprüche, wobei der Kunststoff zumindest einer der Passivierungsschichten (6a, 6b) Polyimid umfasst.

5. Piezostack (10) nach Anspruch 4, wobei der Kunststoff als Lack aufgebracht ist.

6. Piezostack (10) nach Anspruch 4 oder 5, wobei an den Passivierungsschichten (6a,6b) aus Kunststoff jeweils eine elektrische Kontaktierung (7, 8) für die entsprechenden Innenelektroden (11,12) angeordnet sind.

7. Piezostack (10) nach einem der vorhergehenden Ansprüche, wobei der Kunststoff zumindest einer der Passivierungsschichten (6a, 6b) optisch transparent ist.

8. Piezostack (10) nach einem der vorhergehenden Ansprüche, wobei die Passivierungsschicht (9a, 9b) aus Keramik eine Dicke von 5 Mikrometer bis 20 Mikrometer, aufweist.

9. Piezostack (10) nach einem der vorhergehenden Ansprüche, wobei die Passivierungsschicht (6a, 6b) aus Kunststoff eine Dicke von 20 Mikrometer bis 70 Mikrometer, bevorzugt 50 Mikrometer, aufweist.

## Claims

1. Fully active piezo stack (10) having side surfaces (1, 2, 3, 4), wherein
- a passivation layer (9a, 9b) composed of ceramic is arranged on two mutually opposite side surfaces (1, 2) over the respective width,
- a respective passivation layer (6a, 6b) composed of plastic is arranged on the other two mutually opposite side surfaces (3, 4),
such that all the side surfaces (1, 2, 3, 4) are provided with a passivation layer (9a, 9b, 6a, 6b) over the respective width.

2. Piezo stack (10) according to Claim 1, wherein at least one of the passivation layers (9a, 9b) comprising ceramic extends onto one adjoining side surface (3, 4).

3. Piezo stack (10) according to Claim 2, wherein at least one of the passivation layers (9a, 9b) comprising ceramic extends onto both adjoining side surfaces (3, 4).

4. Piezo stack (10) according to any of the preceding claims, wherein the plastic of at least one of the passivation layers (6a, 6b) comprises polyimide.

5. Piezo stack (10) according to Claim 4, wherein the plastic is applied as lacquer.

6. Piezo stack (10) according to Claim 4 or 5, wherein a respective electrical contact-connection (7, 8) for the corresponding internal electrodes (11, 12) is arranged on the passivation layers (6a, 6b) composed of plastic.

7. Piezo stack (10) according to any of the preceding claims, wherein the plastic of at least one of the passivation layers (6a, 6b) is optically transparent.

8. Piezo stack (10) according to any of the preceding claims, wherein the passivation layer (9a, 9b) composed of ceramic has a thickness of 5 micrometers to 20 micrometers.

9. Piezo stack (10) according to any of the preceding claims, wherein the passivation layer (6a, 6b) composed of plastic has a thickness of 20 micrometers to 70 micrometers, preferably 50 micrometers.

## Revendications

1. Pile piézoélectrique (10) entièrement active avec des surfaces latérales (1, 2, 3, 4),
- une couche de passivation (9a, 9b) en céramique étant disposée sur deux surfaces latérales (1, 2) opposées, sur leurs largeurs respectives,
- une couche de passivation (6a, 6b) en matière plastique étant disposée sur les deux autres surfaces latérales (3, 4) opposées,
de façon à ce que toutes les surfaces latérales (1, 2, 3, 4) soient munies, sur toute leur largeur, d'une couche de passivation (9a, 9b, 6a, 6b).

2. Pile piézoélectrique (10) selon la revendication 1, au moins une des couches de passivation (9a, 9b) en céramique s'étendant sur une surface latérale (3, 4) adjacente.

3. Pile piézoélectrique (10) selon la revendication 2, au moins une des couches de passivation (9a, 9b) en céramique s'étendant sur les deux surfaces latérales (3, 4) adjacentes.

4. Pile piézoélectrique (10) selon l'une des revendications précédentes, la matière plastique d'au moins une des couches de passivation (6a, 6b) contenant un polyimide.

5. Pile piézoélectrique (10) selon la revendication 4, la matière plastique étant appliquée sous la forme d'un vernis.

6. Pile piézoélectrique (10) selon la revendication 4 ou 5, un dispositif de contact électrique (7, 8), pour les électrodes internes (11, 12) correspondantes, étant disposé sur chacune des couches de passivation (6a, 6b) en matière plastique.

7. Pile piézoélectrique (10) selon l'une des revendications précédentes, la matière plastique d'au moins une des couches de passivation (6a, 6b) étant optiquement transparente.

8. Pile piézoélectrique (10) selon l'une des revendications précédentes, la couche de passivation (9a, 9b) en céramique présentant une épaisseur de 5 micromètres à 20 micromètres.

9. Pile piézoélectrique (10) selon l'une des revendications précédentes, la couche de passivation (6a, 6b) en matière plastique présentant une épaisseur de 20 micromètres à 70 micromètres, de préférence de 50 micromètres.
